# EUROPÄISCHE PATENTANMELDUNG

(11) **EP 2 362 232 A2**
(43) Veröffentlichungstag der Anmeldung: **31.08.2011**
(21) Anmeldenummer: 11154592.7
(22) Anmeldetag: 15.02.2011
(51) Int. Cl.: G01R 19/25, H01L 31/042

(54) **Überwachungseinheit für Solarmodule**

(30) Priorität: 15.02.2010 DE 102010000422; 01.07.2010 DE 102010017690
(71) Anmelder: Isa Industrieelektronik GmbH, 92637 Weiden i.d. OPf. (DE)
(72) Erfinder: Dr.-Ing. Nitsche, Roland, 92637, Weiden i. d. OPf. (DE)
(74) Vertreter: Lang, Christian

(57) **Zusammenfassung**

Die vorliegende Erfindung betrifft eine Überwachungseinheit (6) für ein Solarmodul mit einem ersten Anschluss und einem zweiten Anschluss, die parallel zu dem zu überwachenden Solarmodul (1 bis 5) geschalten sind, mindestens einer Messeinrichtung (22,23,24) zur Ermittlung mindestens eines Parameters, einer Sendeeinheit (25) zum Senden des mindestens einen Parameterwertes und mit einem Mikroprozessor zur Steuerung der Überwachungseinheit sowie ein Solarmodul und eine entsprechende Solarmodulanordnung.

## Beschreibung

### HINTERGRUND DER ERFINDUNG

### GEBIET DER ERFINDUNG

Die folgende Erfindung betrifft eine Überwachungseinheit für ein Solarmodul sowie eine entsprechende Solarmodulanordnung mit einer Mehrzahl von Solarmodulen mit jeweils einer Überwachungseinheit.

### STAND DER TECHNIK

Die regenerative Energieerzeugung wird für die Energieversorgung immer bedeutsamer und die Anzahl entsprechender Anlagen steigt beständig. Eine besonders erfolgreiche Art der regenerativen Energieerzeugung ist in der photovoltaischen Erzeugung elektrischer Energie gegeben, bei welcher an entsprechenden Halbleiterübergängen bei Lichteinstrahlung elektrische Energie erzeugt werden kann. Die einzelnen photovoltaischen Zellen werden in Solarmodulen zusammengefasst, die wiederum in größeren Anordnungen (Solarmodulanordnungen) zusammengeschlossen werden, um über eine Leistungselektronik elektrische Energie in ein Versorgungsnetz einzuspeisen.

Bei bekannten Solarmodulanordnungen wird eine Überwachung lediglich in der Weise durchgeführt, dass die Energieausbeute der Gesamtanlage überwacht wird. Diese Überwachung ermöglicht zu erkennen, dass beispielsweise auf Grund des Absinkens der Ausgangsleistung ein Fehler in der Anordnung vorliegen muss. Allerdings gibt es zahlreiche Einflüsse auf die Leistungsfähigkeit einer entsprechenden Solarmodulanordnung, sodass alleine mit der entsprechenden Überwachung der Energieausbeute der Gesamtanlage eine Identifizierung des Fehlers schwer möglich ist. Unter Umständen werden bestimmte Fehler gar nicht erkannt, da sie aufgrund der üblichen Leistungsschwankungen in Folge der unterschiedlichen Lichteinstrahlung nicht offensichtlich werden.

### OFFENBARUNG DER ERFINDUNG

### AUFGABE DER ERFINDUNG

Es ist deshalb Aufgabe der vorliegenden Erfindung eine bessere Fehleridentifizierung bei Solarmodulanordnungen zu ermöglichen und eine effiziente Fehlerbehebung zu gewährleisten, wobei der entsprechende Aufwand hierfür gering gehalten werden soll.

### TECHNISCHE LÖSUNG

Diese Aufgabe wird gelöst durch eine Überwachungseinheit für Solarmodule mit den Merkmalen des Anspruchs 1, einem entsprechenden Solarmodul mit den Merkmalen des Anspruchs 8 und einer Solarmodulanordnung mit einer Mehrzahl von Solarmodulen mit den Merkmalen des Anspruchs 9. Vorteilhafte Ausgestaltungen sind Gegenstand der abhängigen Ansprüche.

Die Erfindung schlägt zur Lösung der oben genannten Aufgabe vor, für jedes Solarmodul eine Überwachungseinheit vorzusehen, wobei die Überwachungseinheit mindestens zwei Anschlüsse aufweist, die zu den Anschlüssen eines zu überwachenden Solarmoduls, mittels derer die erzeugte Energie bereit gestellt wird, parallel geschaltet werden. Die Überwachungseinheit weist ferner mindestens eine Messeinrichtung zur Ermittlung mindestens eines Parameters, einen Mikroprozessor zur Steuerung der Überwachungseinheit und eine Sendeeinheit zur Übermittlung des oder der erfassten Parameter oder daraus abgeleiteter Informationen (Signale) auf.

Durch die Einzelüberwachung der einzelnen Solarmodule können Fehler leichter und besser erkannt werden, so dass auch Fehler, die ansonsten nicht identifizierbar gewesen wären, erkannt werden können, und die Fehlerbehebung wird vereinfacht, da feststellbar ist, an welchem Solarmodul der Fehler aufgetreten ist. Es ist nicht mehr erforderlich bei einem festgestellten Fehler in der Solarmodulanordnung, den Fehler in verschiedenen Solarmodulen zu suchen. Durch die verfeinerte Erfassung von Fehlern ist auch eine mögliche Degradation der Zellen frühzeitig erkennbar und durch die Überwachung aller Solarmodule einer Solarmodulanordnung ist auch die Überwachung der Gesamtanlage möglich, wobei zudem bessere und genauere Werte fassbar sind, sodass eine realistischere Bewertung der Leistungsfähigkeit der Gesamtanlage möglich ist.

Nach einer Ausführungsform kann die Überwachungseinrichtung einen Temperatursensor, eine Spannungsmesseinrichtung bzw. ein Spannungsmessgerät, eine Strommesseinrichtung bzw. ein Strommessgerät einzeln oder in Kombination umfassen, sodass Informationen über den tatsächlich abgegebenen Strom, die aktuelle Spannung, die bei einem Solarmodul bereit gestellt wird, und die Temperatur des jeweiligen Moduls erfasst werden können. Neben einzelnen Sensoren oder entsprechenden Geräten, die die zu erfassenden Parameter direkt messen, können auch Einrichtungen bereit gestellt werden, die durch Zusammenwirken mehrerer Komponenten und/oder eine bestimmte Anordnung und/oder Nutzung von Komponenten die erforderlichen Messwerte bereit stellen.

Darüber hinaus kann die Überwachungseinheit eine Modulkennungseinheit umfassen, beispielsweise in Form eines Speicherbausteins, der eine Identifikationsnummer speichert, sodass auch diese Information ähnlich den erfassten Messwerten bzw. Parametern der Messeinrichtungen oder -geräte bereit gestellt werden können.

Insgesamt können mit den ermittelbaren und/oder bereit gestellten Informationen Fehler, wie beispielsweise die Unterbrechung der internen Leiterbahnen, Degradation der Zellen in den Modulen bzw. Kurzschluss in den Anschlusseinheiten spezifisch für jedes Solarmodul festgestellt werden. Durch die Identitätskennung lässt sich zudem ein Diebstahl von Solarmodulen erfassen, wenn beispielsweise die Identifikationsnummer regelmäßig an eine Auswerteeinheit gesendet wird, die das Ausbleiben der Information bei einem Diebstahl erfassen kann. Außerdem können gestohlene Solarmodule leichter wieder aufgefunden werden, wenn eine Abfrage der Identitätskennung in einer Anlage ergibt, dass es sich dabei um ein als gestohlenes Modul registriertes Solarmodul handelt.

Die Überwachungseinheit kann ferner einen Mikrocontroller umfassen, der beispielsweise einen Mikroprozessor der Nanowatt-Technologie aufweist, um eine geringe Leistungsaufnahme zu zeigen, wobei der Mikrocontroller die Daten der Messeinrichtungen und/oder die Identitätskennung über die Sendeeinheit bereitstellt und/oder über eine zusätzliche Verarbeitungseinheit verfügt, die bereits eine erste Auswertung vornehmen kann, sodass auf Basis der Auswertungsergebnisse entsprechende Signale, zum Beispiel in Form von Warnsignalen oder auch Befehlssignale über die Sendeeinheit ausgegeben werden können.

Die Sendeeinheit kann vorzugsweise derart ausgebildet sein, dass eine Daten- und/oder Signalübertragung über die Lastverkabelung des Solarmoduls möglich ist, so dass keine weiteren Anschlüsse vorgesehen werden müssen. Allerdings ist natürlich jede Art einer Kommunikationsverbindung, sei sie drahtlos oder drahtgebunden möglich.

Eine entsprechende Überwachungseinheit kann in einem Solarmodul integriert sein oder lösbar an dem Solarmodul angeordnet sein. Bei einer lösbaren Anordnung ist auch eine entsprechende Nachrüstbarkeit für existierende Solarmodule gegeben.

Bei einer Solarmodulanordnung mit einer Mehrzahl von Solarmodulen, die jeweils eine entsprechende Überwachungseinheit, aufweisen kann eine Auswerteeinheit mit einem Empfangsmodul vorgesehen sein, welche die Daten und/oder Signale der Überwachungseinheiten empfängt und entsprechend auswertet und/oder an eine übergeordnete Einheit weiterleitet.

Eine derartige Auswerteeinheit kann beispielsweise in der Nähe eines Wechselrichters vorgesehen sein und parallel zu diesem geschaltet sein.

### KURZBESCHREIBUNG DER FIGUREN

Weitere Vorteile, Kennzeichen und Merkmale der vorliegenden Erfindung werden bei der nachfolgenden detaillierten Beschreibung eines Ausführungsbeispiels an hand der beigefügten Zeichnungen deutlich. Die Zeichnungen zeigen hierbei in rein schematischer Weise in
Figur 1 eine Darstellung einer Solarmodulanordnung;
Figur 2 eine Darstellung eines Solarmoduls aus der Solarmodulanordnung aus Figur 1;
Figur 3 eine Detaildarstellung eines Solarmoduls und einer Überwachungseinheit gemäß der vorliegenden Erfindung; und in
Figur 4 eine Detaildarstellung der Anordnung einer Auswerteeinheit in der Solarmodulanordnung aus Figur 1.

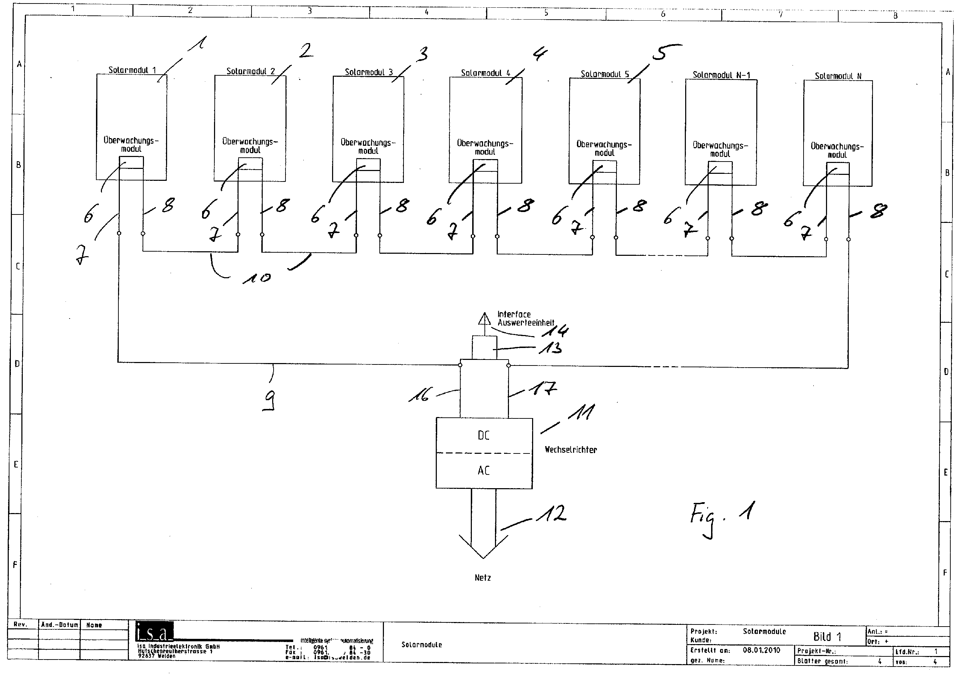

Die Figur 1 zeigt in einer schematischen Schaltdarstellung den Aufbau einer Solarmodulanordnung mit einer Vielzahl von Solarmodulen, nämlich N Solarmodulen 1 bis 5, die über eine entsprechende Lastverkabelung 9, 10 hintereinander in Reihe geschaltet und über die Anschlüsse 16, 17 eines Wechselrichters 11 mit einem Energieversorgungsnetz verbunden sind. Die Solarmodule 1 bis 5 erzeugen durch photovoltaische Zellen bei Lichteinstrahlung an den entsprechenden Halbleiterübergängen elektrische Energie, die über eine geeignete Leistungselektronik, von der der Wechselrichter 11 zumindest einen Teil darstellt, in ein Energieversorgungsnetzwerk eingespeist wird. Jedes Solarmodul 1 bis 5 weist eine Überwachungseinheit 6 auf, die zu den Anschlüssen 7 und 8 der Solarmodule, die mit der Lastverkabelung 9, 10 verbunden sind, parallel geschaltet ist.

Jedes Überwachungsmodul 6 erfasst über nachfolgend näher beschriebene Messeinrichtungen bestimmte Parameter des jeweiligen Solarmoduls 1 bis 5 und übermittelt diese über die vorhandene Verkabelung 9, 10 der Solarmodule 1 bis 5 an eine Auswerteeinheit 13, die zu den Anschlüssen 16, 17 eines Wechselrichters 11 parallel geschaltet ist. Die Auswerteeinheit 13 empfängt die von den jeweiligen Überwachungseinheiten 6 der Solarmodule 1 bis 5 übermittelten Daten und/oder Signale, verarbeitet diese und kann über eine Schnittstelle 14 die überarbeiteten Daten und/oder aus den Daten gewonnene Signale an weitere Einheiten, beispielsweise Alarmmodule und dergleichen übermitteln. Beispielsweise kann die Schnittstelle für die Übertragung von Daten und/oder Signalen für ein Bussystem ausgebildet sein.

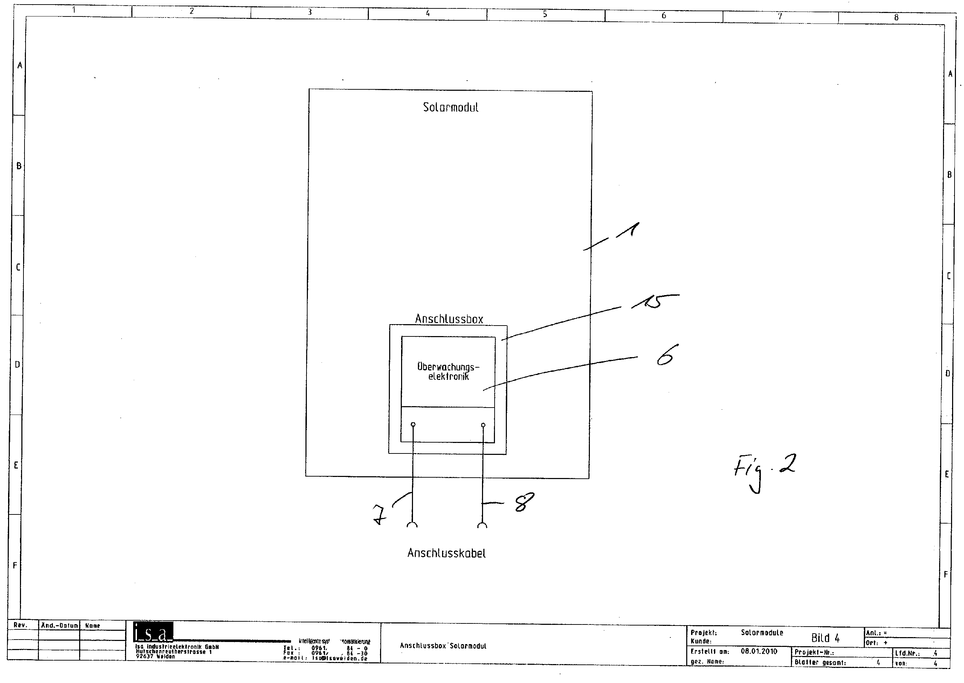

Die Figur 2 zeigt ein einzelnes Solarmodul 1, wie es N-Fach in der Solarmodulanordnung aus Figur 1 vorgesehen ist. Das Solarmodul 1 weist die beiden Anschlüsse 7 und 8 auf, über die die elektrische Energie bereitgestellt wird, die durch die Vielzahl von Solarzellen in dem Solarmodul erzeugt wird. Parallel zu den beiden Last- bzw. Leistungsanschlüssen 7, 8 des Solarmoduls ist die Überwachungseinheit 6 geschaltet, die in einer Anschlussbox 15 des Solarmoduls 1 angeordnet ist. Die Anschlussbox 15 kann derart ausgebildet sein, dass die Überwachungseinheit 6 lediglich in die Anschlussbox 15 eingesteckt werden muss, wobei die eigentlichen Anschlüsse des Solarmoduls 1 genutzt werden und die Anschlüsse 7, 8 durch die Überwachungseinheit 6 hindurchgeführt sind und entsprechend von der eingesteckten Überwachungseinheit 6 bereitgestellt werden.

Alternativ ist es natürlich auch möglich die Überwachungseinheit integral in dem Solarmodul 1 vorzusehen, sodass sie in dem Gehäuse des Solarmoduls mit aufgenommen ist und von außen als solche nicht erkennbar ist, sondern vielmehr in der inneren Verdrahtung des Solarmoduls 1 mit den einzelnen Solarzellen integriert ist.

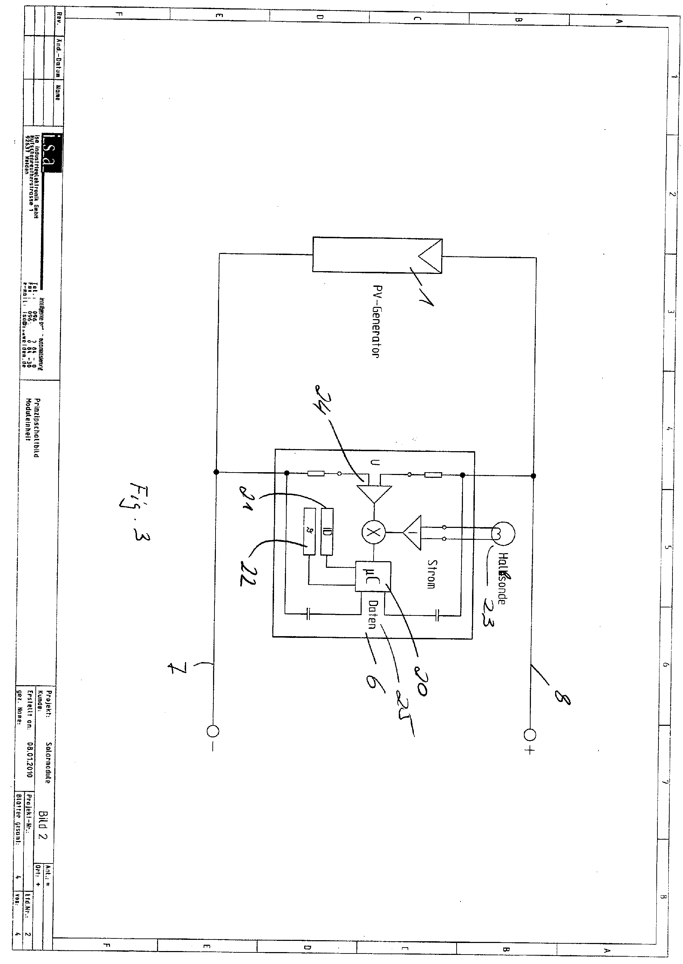

Die Figur 3 zeigt den Aufbau einer Überwachungseinheit 6 in größerem Detail. Bei dieser Darstellung ist das Solarmodul 1 lediglich verkleinert als schematisches Bauteil gezeigt. Allerdings zeigt die Figur 3 deutlich, dass die Überwachungseinheit 6 an den Anschlüssen 7 und 8 und des Solarmoduls 1 parallel geschaltet ist.

Die Überwachungseinheit 6 umfasst einen Mikrocontroller 20, der die Messwerterfassung steuert und dafür sorgt, dass entsprechende Daten und/oder Signale an die Auswerteeinheit 13 ausgegeben werden.

Weiterhin umfasst die Überwachungseinheit 6 in dem gezeigten Ausführungsbeispiel ein Identifizierungsmodul 21, beispielsweise in Form eines Speicherbausteins, in dem eine Seriennummer des Solarmoduls gespeichert ist. Die Seriennummer wird als Identifikationsnummer ID von dem Speicherbaustein 21 ständig oder von Zeit zu Zeit über den Mikrocontroller 20 abgefragt und kann über eine Sendeeinheit 25 der Auswerteeinheit 13 übermittelt werden.

In gleicher Weise ist an den Mikrocontroller 20 ein Temperatursensor 22 angeschlossen, der die Temperatur des Solarmoduls 1 erfasst, welche dann über die Sendeeinheit 25 an die Auswerteeinheit 13 übertragen wird. Darüber hinaus sind ein Strommessgerät 23 in Form einer Hallsonde, die berührungslos den Stromfluss messen kann, sowie eine Spannungsmesseinrichtung 24 vorgesehen, die beispielsweise hochohmig und über eine differenzielle Spannungsmessung die von dem Solarmodul 1 bereitgestellte Spannung misst. Auch die Daten bzw. Messwerte dieser Messeinrichtungen 23, 24 werden von dem Mikrocontroller 20 erfasst und über die Sendeeinheit 25 an die Auswerteeinheit 13 weitergegeben. Die Sendeeinheit 25 ist in dem gezeigten Ausführungsbeispiel als Sendemodul ausgeführt, welches eine Datenübertragung über die Lastverkabelung der Solarmodule ermöglicht. Beispielsweise können hier digitale Modulationsverfahren wie zum Beispiel die Frequenzumtastung (FSK) Verwendung finden.

Neben den gezeigten Einrichtungen, Komponenten und Modulen, sind natürlich auch andersartige Komponenten, Einrichtungen und Module möglich, die gleiche oder ähnliche Funktionen erfüllen. So können beispielsweise andere Strom- und/oder Spannungsmesseinrichtungen und/oder -geräte genauso vorgesehen sein, wie andere Sendeeinheiten, die auf anderem Wege die ermittelten Daten an eine Auswerteeinheit weiterleiten. Der Mikrocontroller 20 kann darüber hinaus in einem eventuell vorgesehenen Bearbeitungsmodul auch selbst Auswertefunktionen übernehmen, sodass statt einer Datenübermittlung auch Befehlssignale basierend auf der Verarbeitung der Daten in dem Mikrocontroller 20 über die Sendeeinheit 25 ausgegeben werden können.

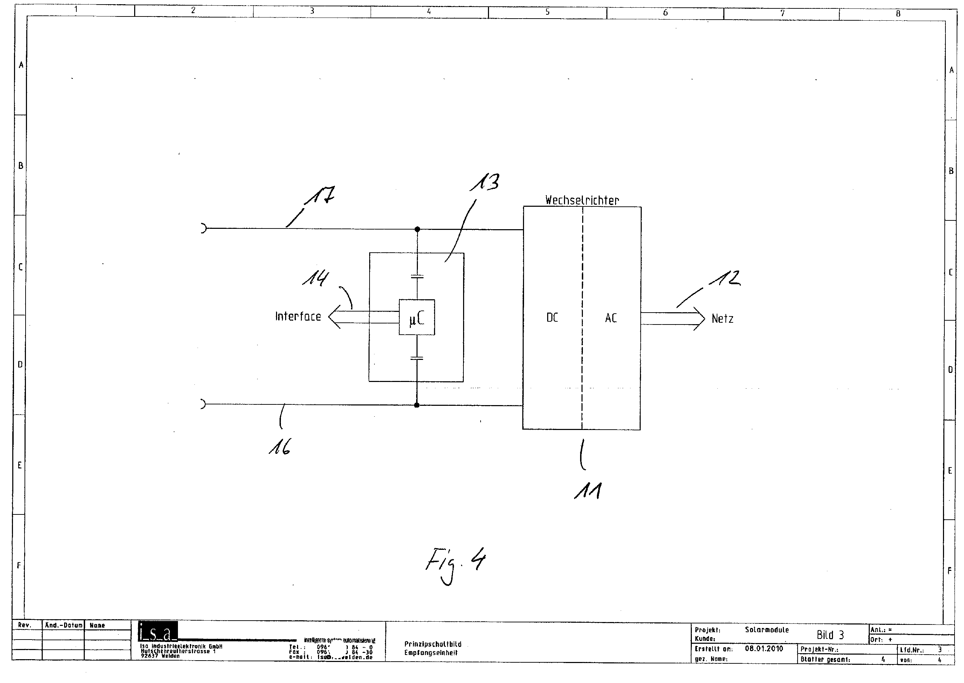

Die Figur 4 zeigt in einer detaillierteren Darstellung die Parallelschaltung der Auswerteeinheit 13 zu den Anschlüssen 16 und 17 des Wechselrichters 11, bei dem die von den Solarmodulen 1 bis 5 bereitgestellte Gleichspannung (DC) in eine Wechselspannung (AC) umgewandelt wird, um dann weiter in das Netz 12 eingespeist zu werden.

Obwohl die vorliegende Erfindung anhand des Ausführungsbeispiels deutlich beschrieben worden ist, ist für den Fachmann selbstverständlich, dass die Erfindung nicht auf dieses Ausführungsbeispiel beschränkt ist, sondern dass Abwandlungen in der Weise möglich sind, dass einzelne Merkmale weggelassen oder andersartige Kombinationen von Merkmalen vorgenommen werden können, ohne den Schutzbereich der beigefügten Ansprüche zu verlassen. Die vorliegende Erfindung umfasst insbesondere sämtliche Kombinationen aller vorgestellten Merkmale.

## Patentansprüche

1. Überwachungseinheit für ein Solarmodul (1 bis 5) mit einem ersten Anschluss und einem zweiten Anschluss, die parallel zu dem zu überwachenden Solarmodul geschaltet sind, mindestens einer Messeinrichtung (22,23,24) zur Ermittlung mindestens eines Parameters, einer Sendeeinheit (25) zum Senden von Daten und/oder Signalen und mit einem Mikroprozessor zur Steuerung der Überwachungseinheit.

2. Überwachungseinheit nach Anspruch 1,
**dadurch gekennzeichnet, dass**
die mindestens eine Messeinrichtung (22,23,24) mindestens eine Einrichtung aus der Gruppe umfasst, die einen Temperatursensor, eine Spannungsmesseinrichtung, ein Spannungsmessgerät, eine Strommesseinrichtung, ein Strommessgerät und einen Hallsensor aufweist.

3. Überwachungseinheit nach Anspruch 1 oder 2,
**dadurch gekennzeichnet, dass**
die Überwachungseinheit einen Mikroprozessor der Nanowatt-Technologie umfasst.

4. Überwachungseinheit nach einem der vorhergehenden Ansprüche,
**dadurch gekennzeichnet, dass**
die Überwachungseinheit eine Modulkennungseinheit (21) umfasst.

5. Überwachungseinheit nach einem der vorhergehenden Ansprüche,
**dadurch gekennzeichnet, dass**
die Sendeeinheit (25) derart hergerichtet ist, dass eine Daten- und/oder Signalübermittlung über die Lastverkabelung der Solarmoduls erfolgt.

6. Überwachungseinheit nach einem der vorhergehenden Ansprüche,
**dadurch gekennzeichnet, dass**
die Überwachungseinheit einen Mikrocontroller (20) umfasst, der die Daten der Messeinrichtung (22,23,24) und/oder einer Identitätskennung (21) unmittelbar oder nach Auswertung in einer Verarbeitungseinheit über die Sendeeinheit bereit stellt.

7. Überwachungseinheit nach einem der vorhergehenden Ansprüche,
**dadurch gekennzeichnet, dass**
die Überwachungseinheit in einem Solarmodul integriert oder lösbar an einem Solarmodul anordenbar ist.

8. Solarmodul mit einer Überwachungseinheit nach einem der vorhergehenden Ansprüche.

9. Solarmodulanordnung mit einer Mehrzahl von Solarmodulen mit einer Überwachungseinheit nach einem der Ansprüche 1 bis 7 und einer Auswerteeinheit (13) mit einem Empfangsmodul, welche die Daten und/oder Signale der Sendeeinheiten der Überwachungseinheiten empfängt und auswertet und/oder weiterleitet.

10. Solarmodulanordnung nach Anspruch 9,
**dadurch gekennzeichnet, dass**
die Anordnung einen Wechselrichter umfasst, zu welchem parallel die Auswerteeinheit geschaltet ist.
